# EUROPEAN PATENT SPECIFICATION

(11) **EP 2 908 150 B1**
(45) Date of publication and mention of the grant of the patent: **27.12.2017**
(21) Application number: 13843849.4
(22) Date of filing: 03.09.2013
(51) Int. Cl.: G01R 33/02

(54) **MAGNETO-IMPEDANCE ELEMENT AND METHOD FOR PRODUCING THE SAME**
MAGNETIMPEDANZELEMENT UND HERSTELLUNGSVERFAHREN DAFÜR
ÉLÉMENT DE MAGNÉTO-IMPÉDANCE ET SON PROCÉDÉ DE FABRICATION

(30) Priority: 04.10.2012 JP 2012222124
(43) Date of publication of application: 19.08.2015
(73) Proprietor: Aichi Steel Corporation, Aichi 476-8666 (JP)
(72) Inventor: NISHIHATA, Katsuhiko, Tokai-shi, Aichi 476-8666 (JP); ITO, Hidenobu, Tokai-shi, Aichi 476-8666 (JP); NAITOH, Norikazu, Tokai-shi, Aichi 476-8666 (JP); MATSUKAWA, Hisatsune, Tokai-shi, Aichi 476-8666 (JP)
(74) Representative: Kuhnen & Wacker
(86) International application number: PCT/JP2013/073698
(87) International publication number: WO 2014/054371

(56) References cited:
- JP-A- 2003 270 310
- JP-A- 2007 292 544
- JP-A- 2008 275 578
- JP-A- 2008 275 578
- US-A1- 2011 046 906

## Description

### Technical Field

The present invention relates to a magneto-impedance element used in portable devices as geomagnetic detector, etc. (appropriately referred to as an "MI element") and a method for producing the same.

### Background Art

Examples of magnetic sensors include Hall effect elements and magneto-resistive elements. In addition, in recent years, a lot of MI elements, which are completely different in structure and principle from conventional elements and have a compact size and incomparably high sensitivity, have been used in portable devices as geomagnetic sensors, etc. The MI elements make use of a magneto-impedance effect (referred to as "MI effect") that when a high-frequency pulsed electric current is applied to a magneto-sensitive body such as an amorphous wire, impedance of the magneto-sensitive body changes in response to a magnetic field surrounding the magneto-sensitive body due to a skin effect.

The MI elements detect magnetism by two methods: a method of directly measuring a change in impedance and a method of measuring a change in magnetic flux passing through a magneto-sensitive body such as a magneto-sensitive wire by a detection coil (a pickup coil) placed around the magneto-sensitive body. A description of an MI element of the latter method is found, for example, in the following patent literature.

### Citation List

### Patent Literature

[PTL 1] WO2010/097932, US 2011/046906, JP 2008 275578.

### Summary of Invention

### Technical Problems

PTL 1 has proposed an MI element having a detection coil which comprises a planar pattern formed on a substrate and an arch-shaped three-dimensional pattern formed on an electrically insulating body fixing an amorphous wire (a magneto-sensitive wire) provided on the planar pattern. Owing to this structure, the detection coil can be placed in vicinity of the magneto-sensitive wire more stably than when a substrate is machine-processed for forming a groove for storing a magneto-sensitive wire. Since the substrate is not processed for forming the groove, the MI element attains overall size reduction in addition to a higher freedom in selecting materials and a higher yield of the substrate.

However, demand for more compact MI elements is continuously growing. In order to further downsize the MI elements and at the same time secure the same level or more than that of output power as those of conventional MI elements, the MI elements having the detection coils require the detection coils to be wound tightly, that is to say, have a fine pitch. In realizing a fine pitch of a detection coil, the MI element of PTL 1 encounters the following problem.

That is to say, in the MI element of PTL 1, the three-dimensional pattern having a height difference of several tens of micrometers is formed by photolithography. The photolithography originally aims to form planar patterns having no height difference. Therefore, it is not easy to form such a three-dimensional pattern as mentioned before with a high resolution by photolithography. Moreover, since a number of MI elements are generally formed on one piece of substrate at one time, products formed through treatments such as photoresist application, exposure and photoresist removal in development, and electric conductor plating tend to have large variations in shape and cannot easily secure stable quality. When pitch of the detection coil is reduced in the MI element of PTL 1 in particular, a variation in shape often causes a short circuit between adjacent joints of the planar pattern and the three-dimensional pattern. Moreover, when the three-dimensional pattern has a great height difference, there is a risk of wire disconnection due to uneven exposure or uneven photoresist removal by development. Therefore, with such a structure as that of PTL 1, it may be difficult to provide an MI element which attains both a high level of output power (e.g., an increase in the number of coil turns) and a high level of size reduction, demand for which grows more and more from now on.

The present invention has been made in view of these circumstances. It is an object of the present invention to provide an MI element having a structure which allows stable formation of a fine-pitch detection coil and attains both size reduction and an increase in output power and a method for producing the same.

### Solution to Problem

The present inventors have earnestly studied and made trials and errors to solve this problem and as a result conceived a structure in which part of a detection coil formed around a magneto-sensitive wire is constituted by electrically conductive bodies (a connecting part) extending in a normal direction of a substrate. The present inventors have developed this idea and completed the present invention mentioned below.

### <Magneto-Impedance Element>

(1) A magneto-impedance element (an MI element) of the present invention comprises a substrate, a magneto-sensitive wire provided above the substrate, a detection coil winding around the magneto-sensitive wire, and an electrically insulating part fixing the magneto-sensitive wire and the detection coil, wherein the detection coil has a first wiring part comprising film-shaped electrically conductive bodies formed along a flat surface of the substrate and crossing the magneto-sensitive wire; a second wiring part comprising film-shaped electrically conductive bodies formed on an opposite side of the magneto-sensitive wire to the first wiring part and crossing the magneto-sensitive wire; and a connecting part comprising columnar or tubular electrically conductive bodies surrounded by the electrically insulating part at both lateral sides of the magneto-sensitive wire and extending in a normal direction of the substrate so as to connect predetermined positions of the first wiring part and those of the second wiring part.
(2) In the MI element of the present invention, a detection coil winding around a magneto-sensitive wire is constituted by a first wiring part, a second wiring part and a connecting part connecting predetermined positions of these wiring parts to each other. The connecting part extends in a normal direction of a substrate above which the magneto-sensitive wire is provided and mainly play a role of generating a difference in height of the detection coil. Since the connecting part extends only in the normal direction of the substrate unlike conventional three-dimensional patterns, the connecting part can be formed with a relatively high precision. Conversely, upon providing the connecting part, not only the first wiring part is formed on the flat substrate but also the second wiring part can be finely fabricated on an approximately planar surface by photolithography. Accordingly, variations are suppressed in production quality of the second wiring part in particular and even when width or pitch of the detection coil is reduced, an MI element can be produced with stable quality, so a fine pitch of a detection coil is easily obtained. In this way, according to the present invention, the number of turns of the detection coil can be easily increased without increasing its size and the MI element can attain both a high level of increase in output power and a high level of size reduction.

### <Method for Producing MI Element>

The MI element of the present invention can be produced by any method, and, for example, can be obtained by the following production method of the present invention. That is to say, the method for producing a magneto-impedance element according to the present invention is a method for producing a magneto-impedance element comprising a substrate, a magneto-sensitive wire provided above the substrate, a detection coil winding around the magneto-sensitive wire, and an electrically insulating part fixing the magneto-sensitive wire and the detection coil, comprising a first-wiring-layer forming step for forming, on a flat surface of the substrate, a first wiring layer to serve as a first wiring part comprising film-shaped electrically conductive bodies capable of crossing the magneto-sensitive wire; an intermediate-layer forming step for forming, on the first wiring layer, an intermediate layer including the electrically insulating part and a connecting part comprising columnar or tubular electrically conductive bodies penetrating the electrically insulating part located at both lateral sides of the magneto-sensitive wire in a normal direction of the substrate; and a second-wiring-layer forming step for forming, on the intermediate layer, a second wiring layer to serve as a second wiring part comprising film-shaped electrically conductive bodies crossing the magneto-sensitive wire; the detection coil being constituted by connecting predetermined positions of the first wiring part and those of the second wiring part by the connecting part.

### <Others>

The present invention can be grasped not only as an MI element but also as a magneto-impedance sensor employing the MI element. For example, the present invention can be a magneto-impedance sensor (an MI sensor) comprising the abovementioned MI element, a pulse oscillation circuit for applying pulse current to the magneto-sensitive wire, and a detection circuit for detecting a voltage variation in the detection coil (including a signal processing circuit, etc.). Since details of the respective circuits of the MI sensor are described in the aforementioned patent literature and the like, their description is omitted here.

### Brief Description of Drawings

[Fig. 1] Fig. 1 is a plan view of an MI element according to Example 1.
[Fig. 2] Fig. 2 is a cross-sectional view cut along line A-A of Fig. 1.
[Fig. 3] Fig. 3 is a partial enlarged view showing an upper-coil-part (second-wiring-part) side of the MI element.
[Fig. 4] Fig. 4 is a cross-sectional view of an MI element according to Example 2.
[Fig. 5] Fig. 5 is a partial enlarged view showing an upper-coil-part (second-wiring-part) side of the MI element.
[Fig. 6A] Fig. 6A is an enlarged view showing that an amorphous wire is held by wire guides provided outside an MI element.
[Fig. 6B] Fig. 6B is a plan view of a substrate having a plurality of such MI elements before divided.
[Fig. 7] Fig. 7 is an enlarged view showing that an amorphous wire is held by an electrically insulating layer for forming via holes.
[Fig. 8] Fig. 8 is an enlarged view showing that an amorphous wire is held by guide posts.

### Modes for Carrying Out the Invention

What is explained in the description of the present invention appropriately applies not only to the MI element of the present invention but also the method for producing the same. Features regarding the manufacturing method, when understood as a product-by-process claim, may also be features regarding a product. One or more constituent features arbitrarily selected from those in the description of the present invention can be added to the aforementioned constituent features of the present invention. Which embodiment is best or not differs depending on an application target, required performance, etc.

### <Detection Coil>

The detection coil according to the present invention becomes a continuous coil winding around the magneto-sensitive wire upon respectively connecting the predetermined positions of the first wiring part and those of the second wiring part by the connecting part as mentioned above. The predetermined positions of the first wiring part or the second wiring part to be connected to the connecting part is not limited as long as a detection coil is formed. In general, the predetermined positions are located in vicinity of end portions of the first wiring part or the second wiring part.

### (1) Wiring Parts

The first wiring part generally comprises film-shaped electrically conductive bodies constituting a (first) wiring pattern formed on a flat surface of a substrate. Therefore, the first wiring part is in parallel with the flat surface of the substrate, but the second wiring part formed on or in the electrically insulating part which covers the first wiring part does not always comprise a (second) wiring pattern which is approximately in parallel with the substrate and planar.

However, it is preferred that the second wiring part (or a second wiring pattern as a collective body of the second wiring part) is formed approximately in parallel with the flat surface of the substrate. In the present invention, such a second wiring part can be easily formed by adjusting height of the connecting part which penetrates the electrically insulating part in the normal direction of the substrate in accordance with an outer diameter of the magneto-sensitive wire to be used. Upon forming the second wiring part, the detection coil placed in vicinity of the magneto-sensitive wire can be formed with stable quality and efficiency. It should be noted that the phrase "approximately in parallel with a flat surface of a substrate" mentioned in the description of the present invention is not limited to a case in which the second wiring pattern of the MI element is in parallel with the flat surface of the substrate in a strict sense. For example, the abovementioned phrase "approximately in parallel with" includes a case in which a second wiring pattern of an MI element as an actual product is smoothly curved due to some production processes or the like. In short, a range of being "approximately in parallel with a flat surface of a substrate" includes any second wiring part formed by general photolithography regardless of which specific form the second wiring part takes, as long as the second wiring pattern is not formed in a convex shape or the like on purpose.

### (2) Connecting Part

The connecting part comprises columnar or tubular electrically conductive bodies extending in the normal direction of the substrate. For example, when the MI element is formed in a multi-layered structure, the connecting part is formed by filling or attaching an electric conductor to via holes or through holes.

The connecting part may have a constant or varied cross-sectional shape in the normal direction of the substrate. For example, when the electrically insulating part according to the present invention has a three-layered structure, it is preferred to form connecting parts which are respectively appropriate to the three layers of the electrically insulating part. That is to say, when the electrically insulating part comprises a first insulating part formed on the first wiring part, an intermediate insulating part formed on the first insulating part and having the magneto-sensitive wire buried therein, and a second insulating part formed on the intermediate insulating part, it is preferred that the connecting part comprises a first connecting part penetrating the first insulating part in the normal direction of the substrate and connected to predetermined positions of the first wiring part, an intermediate connecting part penetrating the intermediate insulating part at both lateral sides of the magneto-sensitive wire in the normal direction of the substrate and connected to the first connecting part, and a second connecting part penetrating the second insulating part in the normal direction of the substrate and connected to the intermediate connecting part and predetermined positions of the second wiring part.

In this case, it is preferred that the intermediate connecting part has a greater column or tube thickness than the first connecting part or the second connecting part. In this case, even if the first connecting part and the second connecting part are finely fabricated in order to make a fine-pitch detection coil, an acceptable position range of joints of the first connecting part and the intermediate connecting part or joints of the second connecting part and the intermediate connecting part is increased and electric connection between these connecting parts is stably established. It should be noted that because of having no need to fix the magneto-sensitive wire, the first insulating part and the second insulating part can be formed relatively thin. Accordingly, both the first connecting part to be connected to the first wiring part and the second connecting part to be connected to the second wiring part are relatively short in the normal direction of the substrate and can be easily formed with high dimensional stability and small dimensional variations.

Conversely, the intermediate connecting part penetrating the intermediate insulating part needs to secure a greater height than a size (a diameter) of the magneto-sensitive wire, and has to be relatively long in the normal direction of the substrate. However, key points in realizing a fine pitch are to prevent short circuit between adjacent joints of the first wiring part and the second wiring part and to prevent disconnection from being caused by the aforementioned production variations. In these respects, the present invention can stably form the first connecting part and the second connecting part as mentioned above and at the same time can form the second wiring part with stable quality by adjusting height of the connecting part as mentioned before. Therefore, the present invention can easily realize a fine pitch and effectively prevent disconnection. Moreover, upon given a great column or tube thickness, the intermediate connecting part which has a greater height difference and tends to have production variations can be easily produced by photolithography. It should be noted that since the intermediate connecting part is not a part to be directly connected to the first wiring part or the second wiring part, and positions of the intermediate connecting part are different from those of the first wiring part or the second wiring part in the normal direction, a great column or tube thickness of the intermediate wiring part hardly causes the aforementioned problem of short circuit.

Furthermore, when the intermediate connecting part has a great column or tube thickness, electric resistance of the entire connecting parts is reduced, which leads to an increase in output power of the MI element. It should be noted that column or tube thickness of the respective connecting parts mentioned in the description of the present invention can be determined by cross-sectional area of the respective connecting parts in respective joint boundary surfaces in parallel with the flat surface of the substrate.

By the way, when pitch of the detection coil is reduced, a decrease in pitch of the first wiring part and that of the second wiring part are necessary together with a decrease in film width of the first wiring part and that of the second wiring part. In this case, it is possible to design the entire connecting parts to have a column or tube thickness approximately as small as the film width of the respective wiring parts, but it is not easy to form connecting parts which are fine and long in the normal direction of the substrate.

If the connecting part is not arranged in line along the extending direction of the magneto-sensitive wire and adjacent ones of the columnar or tubular conductive bodies of the connecting part along that extending direction are shifted from each other, pitch of the connecting parts and pitch of the wiring parts can be reduced while securing a certain level of column or tube thickness of the connecting parts. In other words, it is preferred that adjacent ones of the columnar or tubular conductive bodies of the connecting part according to the present invention along the extending direction of the magneto-sensitive wire have different gaps with the magneto-sensitive wire.

Such adjacent ones of the columnar or tubular conductive bodies of the connecting part can take a variety of arrangement patterns. For example, in some cases, adjacent ones of the columnar or tubular conductive bodies of the connecting part are arranged alternately on certain two lines on each side of the magneto-sensitive wire. Note that the amount of shift (gap with or eccentric distance from the magneto-sensitive wire) of adjacent ones of the columnar or tubular conductive bodies of the connecting part is appropriately adjusted in accordance with required pitch or size of the connecting part. It should be noted that what is described here applies not only to a connecting part having almost constant cross-sectional shape but also a connecting part comprising the first connecting part, the second connecting part and the intermediate connecting part having different cross-sectional shapes as mentioned above.

### <Production Method>

As mentioned before, the MI element of the present invention can be obtained, for example, by way of a first-wiring-layer forming step for forming, on a flat surface of a substrate, a first wiring layer to serve as a first wiring part; an intermediate-layer forming step for forming, on the first wiring layer, an intermediate layer including an electrically insulating part fixing a magneto-sensitive wire and a connecting part penetrating the electrically insulating part in the normal direction of the substrate at both lateral sides of the magneto-sensitive wire; and a second-wiring-layer forming step for forming, on the intermediate layer, a second wiring layer to serve as a second wiring part. Such a multi-layered structure can be obtained mainly by photolithography, which is used for production of buildup multilayer wiring boards, etc.

Here, when the intermediate layer is formed in such a three-layer structure as mentioned above, the intermediate-layer forming step can be as follows. That is, preferably the intermediate-layer forming step comprises a first-insulating-layer forming step for forming a first insulating layer to serve as a first insulating part on the first wiring layer; a connecting-part forming step for forming a first connecting part penetrating the first insulating layer in the normal direction of the substrate and connected to the predetermined positions of the first wiring part, an intermediate connecting part connected to the first connecting part and extending in the normal direction of the substrate at both the lateral sides of the magneto-sensitive wire, and a second connecting part connected to the intermediate connecting part, extending in the normal direction of the substrate and capable of being connected to the predetermined positions of the second wiring part; an intermediate-insulating-layer forming step for forming, on the first insulating layer, an intermediate insulating layer to serve as an intermediate insulating part having the magneto-sensitive wire buried therein; and a second-insulating-layer forming step for forming, on the intermediate insulating layer, a second insulating layer to serve as a second insulating part surrounding the second connecting part; the first insulating layer, the intermediate insulating layer and the second insulating layer constitute the electrically insulating part; and the first connecting part, the intermediate connecting part and the second connecting part constitute the connecting part.

Here, formation of the connecting part can be carried out, for example, by forming a Ti/Cu seed layer and copper plating. Specifically, the connecting part can be formed by a method comprising the steps of forming an electrically insulating layer having via holes by photolithography beforehand and filling plating copper in the via holes. The connecting part can also be formed by forming a resin layer having via holes corresponding the connecting part by photolithography, filling plating metal in the via holes, removing the resin layer and then forming an electrically insulating layer again. It is preferred to appropriately select a most suitable production method in consideration of productivity, etc. When the connecting part comprise the first connecting part, the intermediate connecting part and the second connecting part, it is possible to form these connecting parts independently of each other but it is more efficient to form all the connecting parts at one time.

### Description of Embodiments

### Example 1

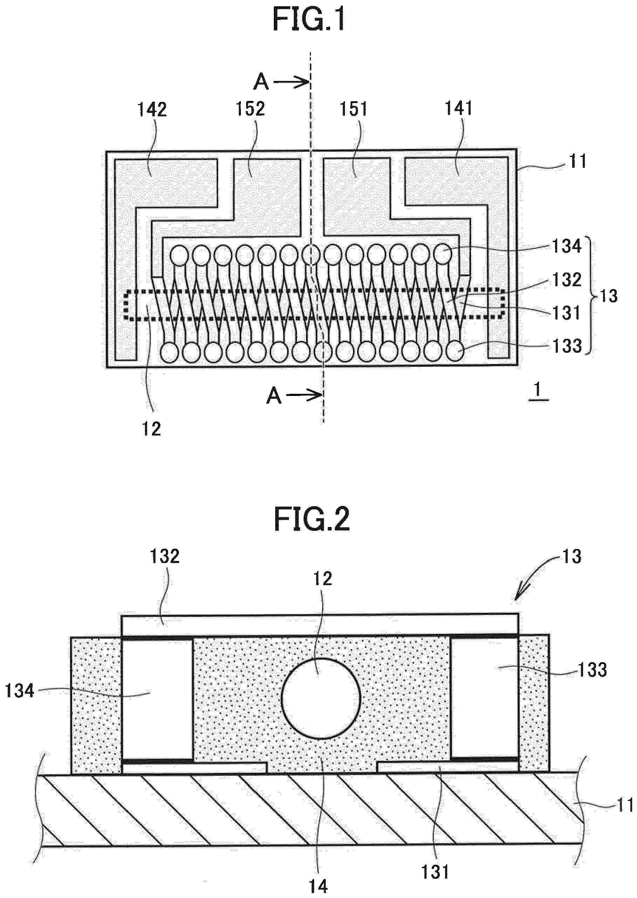

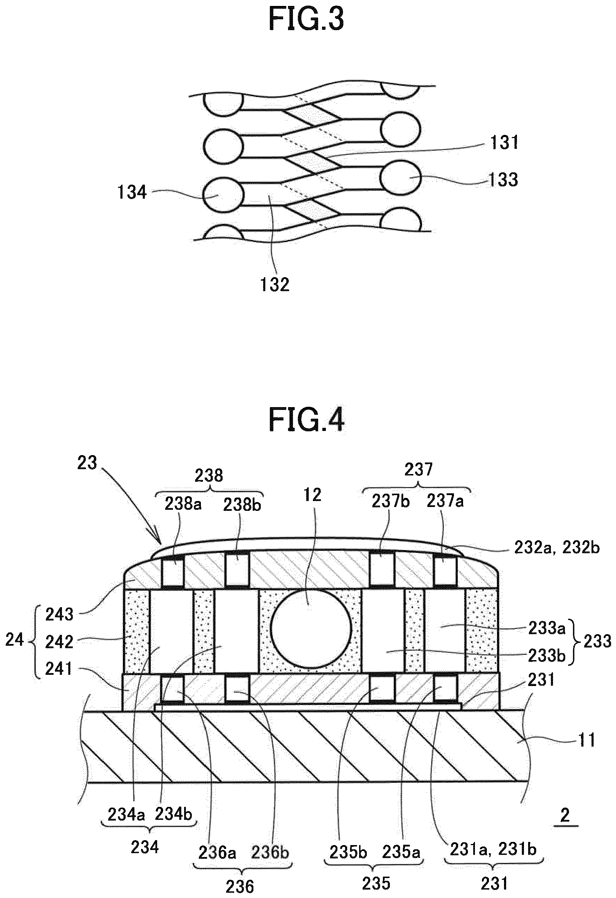

An outline of an MI element 1 according to one example of the present invention is shown in Figs. 1 to 3. Fig. 1 is a plan view of the MI element 1. Fig. 2 is a cross-sectional view taken along line A-A of Fig. 1. Fig. 3 is a partial enlarged view of an upper-coil-part-132 side of a detection coil 13 mentioned later (with an amorphous wire 12 not shown).

The MI element 1 comprises a substrate 11, the amorphous wire 12 (a magneto-sensitive wire) provided above the substrate 11, the detection coil 13 winding around an outer circumference of the amorphous wire 12, an insulating resin body 14 (an electrically insulating part) holding the amorphous wire 12 and the detection coil 13.

The detection coil 13 comprises lower coil portions 131 (a first wiring part) comprising a plurality of copper foils (film-shaped electrically conductive bodies) formed on a flat surface of the substrate 11 and obliquely crossing under the amorphous wire 12; posts 133, 134 (a connecting part) comprising copper posts (columnar electrically conductive bodies) located at both lateral sides of the amorphous wire 12 and extending respectively from end portions of the lower coil portions 131 in a normal direction of the flat surface of the substrate 11; and upper coil portions 132 (a second wiring part) comprising a plurality of copper foils formed on an upper surface of the insulating resin body 14, obliquely crossing over the amorphous wire 12 and having end portions respectively connected to the posts 133, 134.

Although having the same width and length, the lower coil portions 131 and the upper coil portions 132 have different inclinations with respect to the extending direction of the amorphous wire 12 (See Fig. 1) . That is to say, the lower coil parts 131 and the upper coil portions 132 respectively constitute parts of the spiral detection coil 13. Similarly, positions of joints of the lower coil portions 131 and lower end portions of the posts 133, 134 and those of joints of the upper coil parts 132 and upper end portions of the posts 133, 134 are spirally located with respect to the extending direction of the amorphous wire 12. Thus, the lower coil portions 131, the upper coil portions 132 and the posts 133, 134 form the detection coil 13 winding around the amorphous wire 12.

It should be noted that in this example, a substrate of alumina (ceramic/a non-magnetic material) was used as the substrate 11. Material, size, etc. of a substrate to be used in the present invention are not particularly limited and, for example, can be a silicon wafer instead of the alumina substrate. Furthermore, a glass-coated wire comprising a Co-Fe-Si-B-based alloy and having a diameter of 10 to 30 µm was used as the amorphous wire 12.

Formation of a lower wiring layer (a first wiring layer) comprising the lower coil portions 131 (a first-wiring-layer forming step), formation of an intermediate layer comprising the insulating resin body 14 and the posts 133, 134 (an intermediate-layer forming step), and formation of an upper wiring layer (a second wiring layer) comprising the upper coil portions 132 (a second-wiring-layer forming step) were mainly carried out by photolithography. Specifically, formation of these layers were carried out by formation of a thin Ti/Cu seed layer, photoresist application, light exposure through a mask, development, copper plating, photoresist removal, Ti/Cu seed layer removal by selective etching, etc. In this case, the upper wiring layer comprising the upper coil portions 132 were formed approximately in parallel with the flat surface of the substrate 11. The posts 133, 134 were formed by filling plating copper into via holes in an electrically insulating layer comprising the insulating resin body 14. The insulating resin body 14 was formed by dropping liquid epoxy resin diluted with a solvent around the amorphous wire 12 provided above the flat surface of the substrate 11 and thermosetting this epoxy resin.

Note that terminals 141, 142 of the amorphous wire 12 and terminals 151, 152 of the detection coil 13 were formed on the flat surface of the substrate 11 together with the lower coil portions 131.

### Example 2

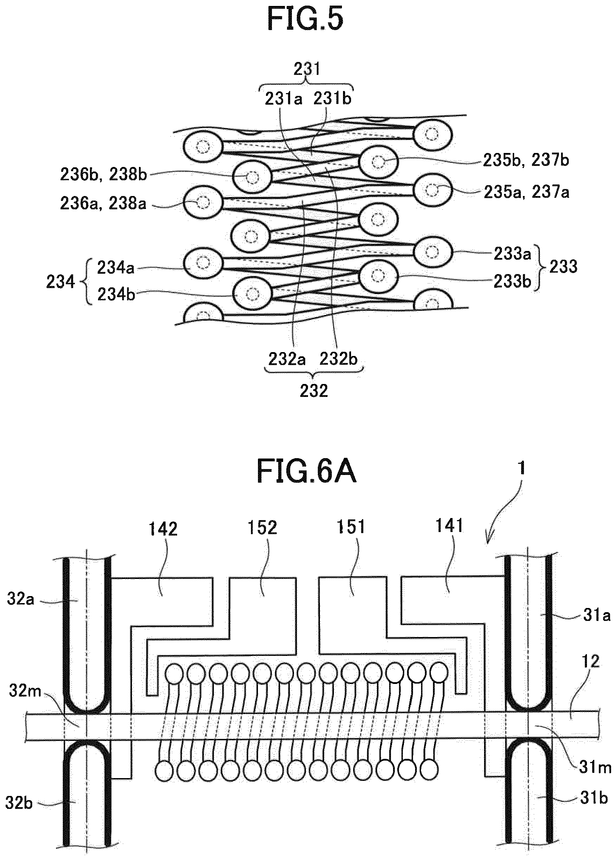

An outline of an MI element 2 according to another example of the present invention is shown in Figs. 4 and 5. Fig. 4 is a cross-sectional view similar to Fig. 2. Fig. 5 is a partial enlarged view of an upper-coil-part-232 side of a detection coil 23 mentioned later (with an amorphous wire 12 not shown) . It should be noted that the same reference numerals are assigned to similar components to the aforementioned components of Example 1 and their description is omitted. Besides, although a cross-sectional view of the MI element 2 cut along a certain line does not normally show some posts (some portions of a connecting part) or some coil parts (some portions of wiring parts), the cross-sectional view of Fig. 4 illustrates all the coil parts and the posts for the convenience of further description.

The MI element 2 comprises a substrate 11, the amorphous wire 12 provided above the substrate 11, the detection coil 23 winding around an outer circumference of the amorphous wire 12, and an insulating resin body 24 (an electrically insulating part) holding the amorphous wire 12 and the detection coil 23.

The detection coil 23 comprises lower coil portions 231a, 231b (these portions are collectively called "lower coil portions 231"/a first wiring part) formed on a flat surface of the substrate 11 and comprising copper foils of the same length alternately shifted and obliquely crossing under the amorphous wire 12; outer lower posts 235a, 236a and inner lower posts 235b, 236b (these posts are collectively called "lower posts 235, 236"/a first connecting part) comprising small-diameter copper posts located at both lateral sides below the amorphous wire 12 and extending respectively from end portions of the lower coil portions 231 in a normal direction of the flat surface of the substrate 11; outer intermediate posts 233a, 234a and inner intermediate posts 233b, 234b (these posts are collectively called "intermediate posts 233, 234"/an intermediate connecting part) comprising large-diameter copper posts located at both lateral sides of a center of the amorphous wire 12 and extending respectively from the outer lower posts 235a, 236a and the inner lower posts 235b, 236b in the normal direction of the substrate 11; outer upper posts 237a, 238a and inner upper posts 237b, 238b (these posts are collectively called "upper posts 237, 238"/a second connecting part) comprising small-diameter copper posts located at both lateral sides above the amorphous wire 12 and extending respectively from the outer intermediate posts 233a, 234a and the inner intermediate posts 233b, 234b in the normal direction of the flat surface of the substrate 11; and upper coil portions 232a, 232b (these portions are collectively called "upper coil portions 232"/a second wiring part) comprising a plurality of copper foils of a long length and a short length formed on an upper surface of the insulating resin body 24 and obliquely crossing over the amorphous wire 12.

The insulating resin body 24 comprises a lower insulating part 241 (a first insulating part) formed on the lower coil parts 231 and surrounding the lower posts 235, 236, an intermediate insulating part 242 (an intermediate insulating part) formed on the lower insulating part 241 and surrounding the intermediate posts 233, 234, and an upper insulating part 243 (a second insulating part) formed on the intermediate insulating part 242 and surrounding the upper posts 237 and 238.

In this way, the MI element 2 has three layers between the lower coil portions 231 and the upper coil portions 232, that is to say, a first layer comprising the lower posts 235, 236 and the lower insulating part 241, an intermediate layer comprising the intermediate posts 233, 234 and the intermediate insulating part 242, and a second layer comprising the upper posts 237, 238 and the upper insulating part 243.

Moreover, in the case of the MI element 2, the lower posts 235, 236, the intermediate posts 233, 234 and the upper posts 237, 238 (these posts are collectively and simply called "posts 239" (a connecting part)) are arranged in two lines of an inner line close to the amorphous wire 12 and an outer line distant from the amorphous wire 12 along the extending direction of the amorphous wire 12. That is to say, adjacent ones of the posts 239 along the extending direction of the amorphous wire 12 are alternately shifted in a zigzag pattern.

In agreement with the configuration of these posts 239, the lower coil portions 231 and the upper coil portions 232 are formed as shown in Fig. 5. Specifically, end portions of the lower coil portions 231a are respectively connected to the lower posts 235a, 236b, and end portions of the lower coil portions 231b are respectively connected to the lower posts 235b, 236a. Moreover, end portions of the upper coil portions 232a are respectively connected to the outer upper posts 237a, 238a, and end portions of the upper coil portions 232b are respectively connected to the inner upper posts 237b, 238b. The lower coil portions 231a and the lower coil portions 231b respectively have the same width and length, but adjacent ones of these portions along the extending direction of the amorphous wire 12 are alternately shifted. The upper coil portions 232a and the upper coil portions 232b have the same width, but since both the end portions of the upper coil portions 232a are connected to the outer upper posts 237a, 238a, the upper coil portions 232a are longer than the upper coil portions 232b having both the end portions connected to the inner upper posts 237b, 238b. Adjacent ones of the upper coil portions 232a and the upper coil portions 232b are alternately shifted along the extending direction of the amorphous wire 12 in the same manner as the lower coil portions 231.

Upon thus spirally arranged along the extending direction of the amorphous wire 12, the lower coil portions 231, the upper coil portions 232 and the posts 239 constitute the detection coil 23 winding around the amorphous wire 12.

Since adjacent ones of the posts 239 along the extending direction of the amorphous wire 12 are arranged in a zigzag pattern in the detection coil 23 according to the present example, although the intermediate posts 233, 234 have a greater thickness than the lower posts 235, 236 or the upper posts 237, 238, intervals (pitch) of the intermediate posts 233, 234 can be decreased. Therefore, pitch of the detection coil 23 in the extending direction of the amorphous wire 12 can be decreased, and as a result, owing to the fine pitch, the MI element 2 can attain both an increase in output power and size reduction.

Such an MI element 2 can be obtained by photolithography, just like the MI element 1, via formation of a lower wiring layer (a first wiring layer) comprising the lower coil portions 231 (a first-wiring-layer forming step), formation of an intermediate layer comprising the insulating resin body 24 and the posts 239 (an intermediate-layer forming step), and formation of an upper wiring layer (a second wiring layer) comprising the upper coil portions 232 (a second-wiring-layer forming step).

More specifically, the intermediate layer is produced via formation of a first insulating layer to serve as the lower insulating part 241 on the lower wiring layer (a first-insulating-layer forming step), formation of the lower posts 235, 236 (a first connecting part) penetrating the first insulating layer in the normal direction of the substrate 11, the intermediate posts 233, 234 (an intermediate connecting part) connected to the lower posts 235, 236 and extending in the normal direction of the substrate 11, and the upper posts 237, 238 (a second connecting part) connected to the intermediate posts 233, 234 and extending in the normal direction of the substrate 11 (a connecting-part forming step), formation of an intermediate insulating layer to serve as the intermediate insulating part 242 (an intermediate insulating part) having the amorphous wire 12 buried therein on the first insulating layer (an intermediate-insulating-layer forming step), and formation of a second insulating layer to serve as the upper insulating part 243 (a second insulating part) on the intermediate insulating layer (a second-insulating-layer forming step). The lower insulating part 241, the intermediate insulating part 242 and the upper insulating part 243 constitute the insulating resin body 24 (an electrically insulating part), and the lower posts 235, 236, the intermediate posts 233, 234, and the upper posts 237, 238 constitute the posts 239 (a connecting part).

It should be noted that the upper coil portions 232 according to the present example were formed so as to be in parallel with the flat surface of the substrate 11 just like the lower coil portions 231. In practice, however, the upper coil portions 232 had upwardly slightly curved surfaces. The surfaces with this level of curve can be regarded as being approximately in parallel with the flat surface of the substrate 11.

### <Placement of Magneto-Sensitive Wire>

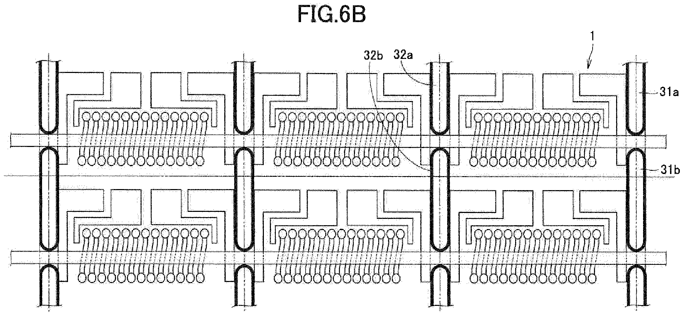

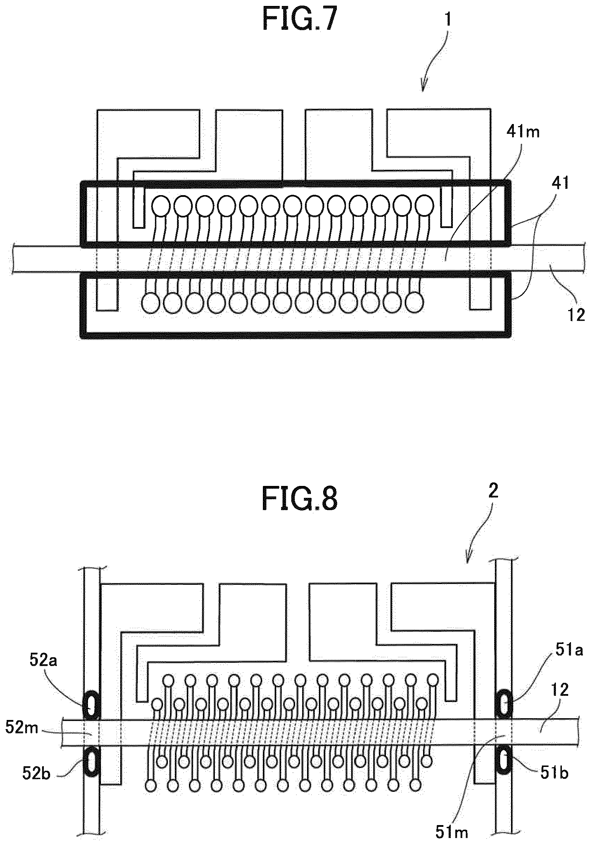

(1) If the magneto-sensitive wire is not precisely placed in a desired position (generally a center) in the detection coil which comprises the first wiring part, the second wiring part and the connecting part for connecting these wiring parts, detection precision of the MI element may decrease or a malfunction of the MI element may occur due to a short circuit between the magneto-sensitive wire and the detection coil.
   Therefore, it is preferred to form the detection coil and the electrically insulating part of the MI element while keeping the magneto-sensitive wire in the desired position by wire guides, etc. Such wire guides can be provided independently of the components (the detection coil, the insulating part, etc.) of the MI element or their production steps, or by making use of these components or their production steps. Specific examples of such wire guides will be described hereinafter.
(2) First, an example is shown in Figs. 6A and 6B, in which magneto-sensitive wires are held in desired positions by providing specialized wire guides independently of the components of MI elements. Fig. 6A is an enlarged view of one MI element 1 and Fig. 6B shows a number of MI elements 1 arranged on a single piece of substrate 11 before divided. In this example, grooves 31m, 32m formed beforehand at both sides of the MI elements 1 help amorphous wires 12 to be placed and held precisely in desired positions. Note that the grooves 31m, 32m are formed by resin guides 31a, 31b and resin guides 32a, 32b formed of an electrically insulating resin and placed adjacent to the aforementioned photolithography patterns.
(3) Second, an example is shown on an enlarged scale in Fig. 7, in which a magneto-sensitive wire is held in a desired position by wire guides which make use of the components of an MI element. In this example, a longitudinally extending groove 41m formed in an insulating resin layer 41 to form via holes for forming posts 133, 134 of the MI element 1 helps the amorphous wire 12 to be placed and held precisely in a desired position. In this case, since there is no need to provide such wire guides as the abovementioned resin guides independently outside an MI element, MI elements before divided can be placed on a single piece of substrate more closely to each other. As a result, the number of MI elements produced from a single piece of substrate can be increased and effective use (an increase in yield rate) of the substrate can be achieved. Moreover, when a plurality of MI elements are cut out from a single piece of substrate and no resin layer such as resin guides is present in cutting lines (see two-dotted lines in Figs. 6A, 6B), efficient cut is realized because cutting conditions specialized for a substrate (silicon, ceramic, etc.) can be set.
(4) Moreover, posts (portions of a connecting part) adjusted to have desired intervals can be used instead of the aforementioned resin layer (the electrically insulating part) to form the via holes. For example, in a case of the MI element 2, the inner intermediate posts 233b, 234b (see Fig. 4), which are closer to the amorphous wire 12, can be used as wire guides. In this case, since the posts and the amorphous wire, which are both electric conductors, need to be electrically insulated, it is preferred to use an amorphous wire having an electrically insulating coating as a magneto-sensitive wire.
(5) Furthermore, in forming posts, guide posts to serve as wire guides can be formed independently of posts which constitute a detection coil. One example is shown in Fig. 8, in which guide posts 51a, 51b, 52a, 52b having smaller intervals than those of inner intermediate posts 233b, 234b of an MI element 2 are formed outside the MI element 2. In this case, an amorphous wire 12 is placed and held in a desired position by a groove 51m formed by the guide posts 51a, 51b and a groove 52m formed by the guide posts 52a, 52b. By thus using the guide posts 51a, 51b, 52a, 52b having smaller intervals than the inner intermediate posts 233b, 234b as wire guides, a magneto-sensitive wire can be used without having any electrically insulating coating unlike the case of using the inner intermediate posts 233b, 234b as wire guides.

Since such guide posts are formed by copper plating just like the posts which constitute the detection coil, it is preferred that when provided inside an MI element, the guide posts are arranged in such configuration (a diameter, a height) not to contact lower coil portions, upper coil portions or posts which constitute the detection coil. Note that even if such guide posts are provided outside an MI element as shown in Fig. 8, a decrease in material yield or a decrease in cutting performance hardly occurs because the guide posts can be formed in a smaller size than the aforementioned resin guides formed of the electrically insulating resin (see Figs. 6A and 6B).

### Reference Signs List

1, 2 MI element
11 substrate
12 amorphous wire (magneto-sensitive wire)
13, 23 detection coil
14, 24 insulating resin body (electrically insulating part)

## Claims

1. A magneto-impedance element (1, 2), comprising
a substrate (11);
a magneto-sensitive wire (12) provided above the substrate (11);
a detection coil (13, 23) winding around the magneto-sensitive wire (12); and
an electrically insulating part (14, 24) fixing the magneto-sensitive wire (12) and the detection coil (13, 23) ;
wherein the detection coil (13, 23) has
a first wiring part (131, 231) comprising film-shaped electrically conductive bodies formed along a flat surface of the substrate (11) and crossing the magneto-sensitive wire (12);
a second wiring part (132, 232) comprising film-shaped electrically conductive bodies formed on an opposite side of the magneto-sensitive wire (12) to the first wiring part (131, 231) and crossing the magneto-sensitive wire (12); and
a connecting part (133, 134) comprising columnar or tubular electrically conductive bodies surrounded by the electrically insulating part (14, 24) at both lateral sides of the magneto-sensitive wire (12) and extending in a normal direction of the substrate (11) so as to connect predetermined positions of the first wiring part (131) and those of the second wiring part (132),
**characterized in that**
the magneto-sensitive wire (12) has a circular cross section and a diameter of 10 to 30 µm.

2. The magneto-impedance element according to claim 1, wherein the second wiring part (132) is formed approximately in parallel with the flat surface of the substrate (11).

3. The magneto-impedance element according to claim 1 or 2, wherein
the electrically insulating part (14, 24) comprises a first insulating part (241) formed on the first wiring part (131, 231), an intermediate insulating part (242) formed on the first insulating part (241) and having the magneto-sensitive wire (12) buried therein, and a second insulating part (243) formed on the intermediate insulating part (242) ;
the connecting part (133, 134) comprises a first connecting part (235, 236) penetrating the first insulating part (241) in the normal direction of the substrate (11) and connected to the predetermined positions of the first wiring part (131, 231), an intermediate connecting part (233, 234) penetrating the intermediate insulating part (242) in the normal direction of the substrate (11) at both the lateral sides of the magneto-sensitive wire (12) and connected to the first connecting part (235, 236), and a second connecting part (237, 238) penetrating the second insulating part (243) in the normal direction of the substrate (11) and connected to the intermediate connecting part (233, 234) and the predetermined positions of the second wiring part (132); and
the intermediate connecting part (233, 234) has a greater column or tube thickness than the first connecting part (235, 236) or the second connecting part (237, 238).

4. The magneto-impedance element according to any one of claims 1 to 3, wherein adjacent ones of the columnar or tubular conductive bodies of the connecting part (133, 134) along the extending direction of the magneto-sensitive wire (12) have different gaps with the magneto-sensitive wire (12) .

5. A method for producing a magneto-impedance element (1, 2) comprising a substrate (11), a magneto-sensitive wire (12) provided above the substrate (11), a detection coil (13, 23) winding around the magneto-sensitive wire (12), and an electrically insulating part (14, 24) fixing the magneto-sensitive wire (12) and the detection coil (13, 23), comprising
a first-wiring-layer forming step for forming, on a flat surface of the substrate (11), a first wiring layer to serve as a first wiring part (131, 231) comprising film-shaped electrically conductive bodies capable of crossing the magneto-sensitive wire (12);
an intermediate-layer forming step for forming, on the first wiring layer (131, 231), an intermediate layer including the electrically insulating part (14, 24) and a connecting part (133, 134) comprising columnar or tubular electrically conductive bodies penetrating the electrically insulating part (14, 24) located at both lateral sides of the magneto-sensitive wire (12) in a normal direction of the substrate (11); and
a second-wiring-layer forming step for forming, on the intermediate layer, a second wiring layer to serve as a second wiring part (132) comprising film-shaped electrically conductive bodies crossing the magneto-sensitive wire (12);
the detection coil (13, 23) being constituted by connecting predetermined positions of the first wiring part (131, 231) and those of the second wiring part (132) by the connecting part(133, 134),
**characterized in that**
the magneto-sensitive wire (12) has a circular cross section and a diameter of 10 to 30 µm.

6. The method for producing the magneto-sensitive element according to claim 5, wherein
the intermediate-layer forming step comprises
a first-insulating-layer forming step for forming a first insulating layer to serve as a first insulating part (241) on the first wiring layer;
a connecting-part forming step for forming a first connecting part (235, 236) penetrating the first insulating layer in the normal direction of the substrate (11) and connected to the predetermined positions of the first wiring part (131, 231), an intermediate connecting part (233, 234) connected to the first connecting part (235, 236) and extending in the normal direction of the substrate (11) at both the lateral sides of the magneto-sensitive wire (12), and a second connecting part (237, 238) connected to the intermediate connecting part (233, 234), extending in the normal direction of the substrate (11) and capable of being connected to the predetermined positions of the second wiring part (132);
an intermediate-insulating-layer forming step for forming, on the first insulating layer, an intermediate insulating layer to serve as an intermediate insulating part (242) having the magneto-sensitive wire (12) buried therein; and
a second-insulating-layer forming step for forming, on the intermediate insulating layer, a second insulating layer to serve as a second insulating part (243) surrounding the second connecting part (237, 238);
the first insulating layer, the intermediate insulating layer and the second insulating layer constitute the electrically insulating part (14, 24); and
the first connecting part, the intermediate connecting part and the second connecting part constitute the connecting part (133, 134).

## Patentansprüche

1. Magnetoimpedanzelement (1, 2), aufweisend:
ein Substrat (11);
einen magnetosensiblen Draht (12), der über dem Substrat (11) vorhanden ist;
eine Erfassungsspule (13, 23), die um den magnetosensiblen Draht (12) gewickelt ist; und
ein elektrisches Isolierungsteil (14, 24), das den magnetosensiblen Draht (12) und die Erfassungsspule (13, 23) befestigt;
wobei die Erfassungsspule (13, 23) aufweist:
ein erstes Verdrahtungsteil (131, 231), das filmförmige, elektrisch leitfähige Körper aufweist, die entlang einer flachen Oberfläche des Substrats (11) ausgebildet sind und den magnetosensiblen Draht (12) kreuzen;
ein zweites Verdrahtungsteil (132, 232), das filmförmige, elektrisch leitfähige Körper aufweist, die an einer zu dem ersten Verdrahtungsteil (131, 231) gegenüberliegenden Seite des magnetosensiblen Drahts (12) ausgebildet sind und den magnetosensiblen Draht (12) kreuzen; und
ein Verbindungsteil (133, 134), das säulenförmige oder röhrenförmige, elektrisch leitfähige Körper aufweist, die von dem elektrisch isolierenden Teil (14, 24) an beiden lateralen Seiten des magnetosensiblen Drahts (12) umgeben werden und in einer normalen Richtung des Substrats (11) verlaufen, so dass vorgegebene Positionen des ersten Verdrahtungsteils (131) und diejenigen des zweiten Verdrahtungsteils (132) verbunden werden,
**dadurch gekennzeichnet, dass**
der magnetosensible Draht (12) einen kreisrunden Querschnitt und einen Durchmesser von 10 bis 30 µm aufweist.

2. Magnetoimpedanzelement nach Anspruch 1, wobei das zweite Verdrahtungsteil (132) annähernd parallel zu der flachen Oberfläche des Substrats (11) ausgebildet ist.

3. Magnetoimpedanzelement nach Anspruch 1 oder 2, wobei
das elektrisch isolierende Teil (14, 24) ein erstes isolierendes Teil (241), das auf dem ersten Verdrahtungsteil (131, 231) ausgebildet ist, ein isolierendes Zwischenteil (242), das auf dem ersten isolierenden Teil (241) ausgebildet ist und in dem der magnetosensible Draht (12) eingegraben ist, und ein zweites isolierendes Teil (243), das auf dem isolierenden Zwischenteil (242) ausgebildet ist, aufweist;
das Verbindungsteil (133, 134) ein erstes Verbindungsteil (235, 236), das das erste Isolierungsteil (241) in der normalen Richtung des Substrats (11) penetriert und mit den vorgegebenen Positionen des ersten Verdrahtungsteils (131, 231) verbunden ist, ein Zwischenverbindungsteil (233, 234), das das isolierende Zwischenteil (242) in der normalen Richtung des Substrats (11) an beiden lateralen Seiten des magnetosensiblen Drahts (12) penetriert und mit dem ersten Verbindungsteil (235, 236) verbunden ist, und ein zweites Verbindungsteil (237, 238), das das zweite Verbindungsteil (243) in der normalen Richtung des Substrats (11) penetriert und mit dem Zwischenverbindungsteil (233, 234) und den vorgegebenen Positionen des zweiten Schreibteils (132) verbunden ist, aufweist; und
das Zwischenverbindungsteil (233, 234) eine größere Säulen- oder Röhrendicke aufweist als das erste Verbindungsteil (235, 236) oder das zweite Verbindungsteil (237, 238).

4. Magnetoimpedanzelement nach einem der Ansprüche 1 bis 3, wobei benachbarte von den säulenförmigen oder röhrenförmigen leitfähigen Körpern des Verbindungsteils (133, 134) entlang der Verlaufsrichtung des magnetosensiblen Drahts (12) verschiedene Lücken bei dem magnetosensiblen Draht (12) aufweisen.

5. Verfahren zum Herstellen eines Magnetoimpedanzelements (1, 2), aufweisend ein Substrat (11), einen magnetosensiblen Draht (12), der über dem Substrat (11) vorhanden ist, eine Erfassungsspule (13, 23), die um den magnetosensiblen Draht (12) gewickelt ist, und ein elektrisches Isolierungsteil (14, 24), das den magnetosensiblen Draht (12) und die Erfassungsspule (13, 23) befestigt, aufweisend:
einen ersten Verdrahtungsschichtausbildungsschritt zum Ausbilden einer ersten Verdrahtungsschicht auf einer flachen Oberfläche des Substrats (11), um als ein erstes Verdrahtungsteil (131, 231) zu dienen, das filmförmige, elektrisch leitfähige Körper aufweist, die in der Lage sind, den magnetosensiblen Draht (12) zu kreuzen;
einen Zwischenschichtausbildungsschritt zum Ausbilden einer Zwischenschicht auf der ersten Verdrahtungsschicht (131, 231), die das elektrisch isolierende Teil (14, 24) und ein Verbindungsteil (133, 134) beinhaltet, das säulenförmige oder röhrenförmige elektrisch leitfähige Körper aufweist, die das elektrisch isolierende Teil (14, 24) penetrieren, das sich an beiden lateralen Seiten des magnetosensiblen Drahts (12) in einer normalen Richtung des Substrats (11) befindet; und
einen zweiten Verdrahtungsschichtausbildungsschritt zum Ausbilden einer zweiten Verdrahtungsschicht auf der Zwischenschicht, die als ein zweites Verdrahtungsteil (132) dient, das filmförmige, elektrisch leitfähige Körper aufweist, die den magnetosensiblen Draht (12) kreuzen;
wobei die Erfassungsspule (13, 23) dadurch entsteht, dass vorgegebene Positionen des ersten Verdrahtungsteils (131, 231) und diejenigen des zweiten Verdrahtungsteils (132) durch das Verbindungsteil (133, 134) verbunden werden, **dadurch gekennzeichnet, dass**
der magnetosensible Draht (12) einen kreisrunden Querschnitt und einen Durchmesser von 10 bis 30 µm aufweist.

6. Verfahren zum Herstellen des magnetosensiblen Elements nach Anspruch 5, wobei der Zwischenschichtausbildungsschritt aufweist:
einen ersten Isolierungsschichtausbildungsschritt zum Ausbilden einer ersten Isolierungsschicht, die als ein erstes Isolierungsteil (241) auf der ersten Verdrahtungsschicht dient;
einen Verbindungsteilausbildungsschritt zum Ausbilden eines ersten Verbindungsteils (235, 236), der die erste Isolierungsschicht in der normalen Richtung des Substrats (11) penetriert und mit den vorgegebenen Positionen des ersten Verdrahtungsteils (131, 231) verbunden ist, eines Zwischenverbindungsteils (233, 234), der mit dem ersten Verbindungsteil (235, 236) verbunden ist und in der normalen Richtung des Substrats (11) an beiden lateralen Seiten des magnetosensiblen Drahts (12) verläuft, und eines zweiten Verbindungsteils (237, 238), das mit dem Zwischenverbindungsteil (233, 234) verbunden ist, das in der normalen Richtung des Substrats (11) verläuft und in der Lage ist, mit den vorgegebenen Positionen des zweiten Verdrahtungsteils (132) verbunden zu werden;
einen Zwischenisolierungsschichtausbildungsschritt zum Ausbilden einer Zwischenisolierungsschicht auf der ersten Isolierungsschicht, die als ein Zwischenisolierungsteil (242) mit dem magnetosensiblen Draht (12), der darin eingegraben ist, dient; und
einen zweiten Isolierungsschichtausbildungsschritt zum Bilden einer zweiten Isolierungsschicht auf der Zwischenisolierungsschicht, die als ein zweites Isolierungsteil (243) dient, das das zweite Verbindungsteil (237, 238) umgibt;
wobei die erste Isolierungsschicht, die Zwischenisolierungsschicht und die zweite Isolierungsschicht das elektrisch isolierende Teil (14, 24) darstellen; und
wobei das erste Verbindungsteil, das Zwischenverbindungsteil und das zweite Verbindungsteil das Verbindungsteil (133, 134) darstellen.

## Revendications

1. Élément de magnéto-impédance (1, 2), comprenant
un substrat (11) ;
un câble magnéto-sensible (12) prévu au-dessus du substrat (11) ;
une bobine de détection (13, 23) s'enroulant autour du câble magnéto-sensible (12) ; et
une partie électriquement isolante (14, 24) fixant le câble magnéto-sensible (12) et la bobine de détection (13, 23) ;
dans lequel la bobine de détection (13, 23) comporte
une première partie de câblage (131, 231) comprenant des corps électriquement conducteurs en forme de film formés le long d'une surface plate du substrat (11) et croisant le câble magnéto-sensible (12) ;
une seconde partie de câblage (132, 232) comprenant des corps électriquement conducteurs en forme de film formés sur un côté opposé du câble magnéto-sensible (12) à la première partie de câblage (131, 231) et croisant le câble magnéto-sensible (12) ; et
une partie de raccordement (133, 134) comprenant des corps électriquement conducteurs colonnaires ou tubulaires entourés de la partie électriquement isolante (14, 24) des deux côtés latéraux du câble magnéto-sensible (12) et s'étendant dans une direction normale du substrat (11) de façon à raccorder des positions prédéterminées de la première partie de câblage (131) et celles de la seconde partie de câblage (132),
**caractérisé en ce que**
le câble magnéto-sensible (12) a une section transversale circulaire et un diamètre de 10 à 30 µm.

2. Élément de magnéto-impédance selon la revendication 1, dans lequel la seconde partie de câblage (132) est formée approximativement en parallèle avec la surface plate du substrat (11).

3. Élément de magnéto-impédance selon la revendication 1 ou 2, dans lequel
la partie électriquement isolante (14, 24) comprend une première partie isolante (241) formée sur la première partie de câblage (131, 231), une partie isolante intermédiaire (242) formée sur la première partie isolante (241) et dans laquelle est enterré le câble magnéto-sensible (12), et une seconde partie isolante (243) formée sur la partie isolante intermédiaire (242) ;
la partie de raccordement (133, 134) comprend une première partie de raccordement (235, 236) pénétrant dans la première partie isolante (241) dans la direction normale du substrat (11) et raccordée aux positions prédéterminées de la première partie de câblage (131, 231), une partie de raccordement intermédiaire (233, 234) pénétrant dans la partie isolante intermédiaire (242) dans la direction normale du substrat (11) des deux côtés latéraux du câble magnéto-sensible (12) et raccordée à la première partie de raccordement (235, 236), et une seconde partie de raccordement (237, 238) pénétrant dans la seconde partie isolante (243) dans la direction normale du substrat (11) et raccordée à la partie de raccordement intermédiaire (233, 234) et aux positions prédéterminées de la seconde partie de câblage (132) ; et
la partie de raccordement intermédiaire (233, 234) a une épaisseur de colonne ou de tube supérieure à la première partie de raccordement (235, 236) ou la seconde partie de raccordement (237, 238).

4. Élément de magnéto-impédance selon l'une quelconque des revendications 1 à 3, dans lequel des corps adjacents des corps conducteurs colonnaires ou tubulaires de la partie de raccordement (133, 134) le long de la direction d'extension du câble magnéto-sensible (12) ont des écartements différents avec le câble magnéto-sensible (12).

5. Procédé de production d'un élément de magnéto-impédance (1, 2) comprenant un substrat (11), un câble magnéto-sensible (12) prévu au-dessus du substrat (11), une bobine de détection (13, 23) s'enroulant autour du câble magnéto-sensible (12), et une partie électriquement isolante (14, 24) fixant le câble magnéto-sensible (12) et la bobine de détection (13, 23), comprenant
une étape de formation de première couche de câblage pour former, sur une surface plate du substrat (11), une première couche de câblage devant servir de première partie de câblage (131, 231) comprenant des corps électriquement conducteurs en forme de film capables de croiser le câble magnéto-sensible (12) ;
une étape de formation de couche intermédiaire pour former, sur la première couche de câblage (131, 231), une couche intermédiaire comportant la partie électriquement isolante (14, 24) et une partie de raccordement (133, 134) comprenant des corps électriquement conducteurs colonnaires ou tubulaires pénétrant dans la partie électriquement isolante (14, 24) situés des deux côtés latéraux du câble magnéto-sensible (12) dans une direction normale du substrat (11) ; et
une étape de formation de seconde couche de câblage pour former, sur la couche intermédiaire, une seconde couche de câblage devant servir de seconde partie de câblage (132) comprenant des corps électriquement conducteurs en forme de film croisant le câble magnéto-sensible (12) ;
la bobine de détection (13, 23) étant constituée en raccordant des positions prédéterminées de la première partie de câblage (131, 231) et celles de la seconde partie de câblage (132) par la partie de raccordement (133, 134),
**caractérisé en ce que**
le câble magnéto-sensible (12) a une section transversale circulaire et un diamètre de 10 à 30 µm.

6. Procédé de production de l'élément de magnéto-impédance selon la revendication 5, dans lequel
l'étape de formation de couche intermédiaire comprend
une étape de formation de première couche isolante pour former une première couche isolante devant servir de première partie isolante (241) sur la première couche de câblage ;
une étape de formation de partie de raccordement pour former une première partie de raccordement (235, 236) pénétrant dans la première couche isolante dans la direction normale du substrat (11) et raccordée aux positions prédéterminées de la première partie de câblage (131, 231), une partie de raccordement intermédiaire (233, 234) raccordée à la première partie de raccordement (235, 236) et s'étendant dans la direction normale du substrat (11) des deux côtés latéraux du câble magnéto-sensible (12), et une seconde partie de raccordement (237, 238) raccordée à la partie de raccordement intermédiaire (233, 234), s'étendant dans la direction normale du substrat (11) et capable d'être raccordée aux positions prédéterminées de la seconde partie de câblage (132) ;
une étape de formation de couche isolante intermédiaire pour former, sur la première couche isolante, une couche isolante intermédiaire devant servir de partie isolante intermédiaire (242) dans laquelle est enterré le câble magnéto-sensible (12) ; et
une étape de formation de seconde couche isolante pour former, sur la couche isolante intermédiaire, une seconde couche isolante devant servir de seconde partie isolante (243) entourant la seconde partie de raccordement (237, 238) ;
la première couche isolante, la couche isolante intermédiaire et la seconde couche isolante constituent la partie électriquement isolante (14, 24) ; et
la première partie de raccordement, la partie de raccordement intermédiaire et la seconde partie de raccordement constituent la partie de raccordement (133, 134) .
